(19) **Europäisches Patentamt**

**European Patent Office**

**Office européen des brevets**

(11) **EP 0 459 614 B1**

(12) **EUROPEAN PATENT SPECIFICATION**

(45) Date of publication and mention
of the grant of the patent:
**30.09.1998 Bulletin 1998/40**

(51) Int Cl.6: **C08K 3/36**, C08L 63/00

(21) Application number: **91303323.9**

(22) Date of filing: **16.04.1991**

(54) **Method for preparing a liquid epoxy resin composition**

Verfahren zur Herstellung einer flüssigen Epoxydharzzusammensetzung

Procédé de préparation d'une composition liquide de résine époxyde

(84) Designated Contracting States:
**DE FR GB NL**

(30) Priority: **30.05.1990 JP 140890/90**

(43) Date of publication of application:
**04.12.1991 Bulletin 1991/49**

(73) Proprietor: **SOMAR CORPORATION**
**Tokyo 104 (JP)**

(72) Inventors:
- **Kawano, Takayuki**
  **Kasukabe-shi, Saitama-ken (JP)**
- **Nomura, Mari**
  **Saitama-ken (JP)**
- **Nagase, Rihei**
  **Adachi-ku, Tokyo (JP)**

(74) Representative: **Allam, Peter Clerk et al**
**LLOYD WISE, TREGEAR & CO.,**
**Commonwealth House,**
**1-19 New Oxford Street**
**London WC1A 1LW (GB)**

(56) References cited:
**EP-A- 0 138 209**        **EP-A- 0 350 346**

- **WORLD PATENTS INDEX LATEST Derwent Publications Ltd., London, GB; AN 81-93936D(51)**
- **WORLD PATENTS INDEX Derwent Publications Ltd., London, GB; AN 76-51167X(27)**
- **ANNU. TECH. CONF. SOC. PLAST. ENG. TECH. PAP. 27TH vol. 15, 1969, STAMFORD CONN. pages 66 - 71; LIPPE ROBERT J.: 'IMPROVING THE STABILITY OF THIXOTROPIC EPOXY RESIN COMPOSITIONS'**
- **WORLD PATENTS INDEX Derwent Publications Ltd., London, GB; AN 80410C(45)**

Remarks:
The file contains technical information submitted after the application was filed and not included in this specification

**Description**

This invention relates generally to a method of preparing a liquid epoxy resin composition and, more specifically, to a method for preparing an improved epoxy resin composition suitable for bonding electric parts onto printed wiring boards, and to the improved epoxy resin composition thus prepared.

It is known to use an epoxy resin adhesive composition for bonding electric parts such as IC elements to printed wiring boards. The printed wiring boards thus bearing temporarily mounted parts are then soldered to provide firm bonding therebetween. The epoxy resin composition for use in bonding electric parts is desired to have the following characteristics:

(a) the composition does not spread when applied on a surface of a board;
(b) the composition applied on the surface does not spread when heated to effect curing of the composition; and
(c) the composition is stable and does not undergo changes in viscosity and thixotropy.

Japanese Tokkyo Kokai No. 63-156817 discloses a liquid epoxy resin composition containing an epoxy resin, a curing agent, a filler and hydrophobic silica. The hydrophobic silica which is also called hydrophobic white carbon is used for preventing the sag of the composition at the curing step. This Japanese publication teaches that the use of hydrophilic silica is undesirable because the thixotropy of the resulting epoxy resin composition is lost with time. More particularly, according to this Japanse publication, the thixotropy index of a hydrophobic silica-containing epoxy resin composition is slightly changed from 3.2 to 3.1 and the composition still exhibits good sag-preventing property when the composition is allowed to stand at 25 °C for 20 days. On the other hand, the thixotropy index of a hydrophilic silica-containing epoxy resin composition decreases from 5.2 to 1.4 and the composition no longer shows sag-preventing property after the composition has been kept at 25 °C for 20 days.

It has been found, however, that epoxy resin compositions containing hydrophobic silica do change in their thixotropy and the sag-preventing property is deteriorated when kept at a higher temperature, such as 40°C, for a long time, such as 20 days.

EP-A-138209 discloses an epoxy resin composition which essentially comprises, in addition to the epoxy resin:

(a) a hardener comprising a diaminotriazine-modified imidazole compound and dicyanodiamide, which together also act to improve the storage stability of the composition, and

(b) a thixotropic agent, which may be hydrophilic silica, and which is used in amount to bring the thixotropy index of the whole composition into the range 5-40.

WPIL Derwent Abstract of JP-A-56143281 is also concerned with improving the storage stability of an epoxy resin-containing composition. In this case this is achieved by using as the hardener 2,4-diamino-6-(2'-alkylamidazolyl(1'))-ethyl-5-triazine or an adduct thereof with isocyanuric acid. Again, a hydrophilic silica is added as a thixotropy promoter.

Annu. Tech. Conf. Soc. Plast. Eng. Tech. Pap. 27th, Vol. 15, 1969, pages 66-71 discloses that epoxy resin-silica dispersions in which the silica is not thoroughly dispersed are less stable upon aging than are systems containing thoroughly dispersed particles. However, an increasing degree of dispersion also favours a phenomenon, which develops on aging, termed "after wetting" in which polymer molecules are in intimate contact with the silica particles along the entire length of the molecule. Such "after wetting" results in a failure of aged epoxy-silica dispersions to gel at an adequate rate on addition of diethylamine triamine (DETA) curing agent.

It has now been surprisingly found that hydrophilic silica can serve as a stabilizer for an epoxy resin composition so that the thixotropy and viscosity thereof remain substantially unchanged even when the composition is kept at 40°C for 20 days, and the composition does not spread at the time of curing thereof, if the hydrophilic silica is thoroughly mixed with an epoxy resin and a latent curing agent.

More particularly, the present invention provides a method of preparing a liquid epoxy resin composition, comprising the steps of:

(a) providing a mixture comprising an epoxy resin and hydrophilic silica and having a thixotropy index of at least 4;

(b) blending said mixture with an amine latent curing agent to obtain a blend;

(c) then thoroughly mixing said blend at a temperature of 5°-40°C until the thixotropy index thereof is decreased to 2 or less;

(d) mixing a filler and/or a thixotropic agent with the thoroughly mixed product obtained in step (c); and

wherein the thixotropy index is defined as:

$$v_{0.5}/v_5$$

where $v_{0.5}$ is the viscosity of the composition measured at 25°C with a rotating viscometer operated at a rotational speed of 0.5 revolution per minute and $v_5$ is the viscosity of said composition measured at 25°C with the same viscometer operated at a rotational speed of 5.0 revolutions per minute.

A preferred liquid epoxy resin composition prepared by the method of this invention has a viscosity changing ratio Vc in the range of 0.90 to 1.10, a thixotropy index changing ratio Tc in the range of 0.90 to 1.10 and a coating expansion ratio E in the range of 1.00 to 1.10, said viscosity changing ratio, thixotropy index changing ratio and coating expansion ratio being calculated as follows:

$$Vc = V_1/V_0$$

wherein $V_0$ is the viscosity of said composition at a given point in time and measured at 25°C with a rotating viscometer with a rotation speed of 0.5 r.p.m. and $V_1$ is the viscosity of said composition after being maintained at 40°C for 20 days from said given point in time and measured in the same conditions as above,

$$Tc = T_1/T_0$$

wherein $T_0$ is the thixotropy index of said composition at said given point in time and $T_1$ is the thixotropy index of said composition after being maintained at 40°C for 20 days from said given point in time, where the thixotropy index is calculated as follows:

$$\text{Thixotropy Index} = v_{0.5}/v_5$$

where $v_{0.5}$ and $v_5$ are as defined above, and

$$E = D_1/D_0$$

wherein $D_0$ is the diameter of an uncured coating on a substrate and $D_1$ is the diameter of the coating after curing at 150°C for 1 minute.

The reason why hydrophilic silica, when used in the specific manner of this invention, can serve as a stabilizer for stabilizing the thixotropy of the epoxy resin composition has not yet been clarified. However, since no such a stabilizing effect is obtainable when hydrophobic silica is used in lieu of hydrophilic silica, when the amine latent curing agent is replaced with other curing agents or when the hydrophilic silica is not thoroughly mixed with the amine curing agent, a specific, stable association is considered to be established between the hydrophilic silica and the amine curing agent, presumably through interaction between the OH groups of the hydrophilic silica and the nitrogen atoms of the curing agent, when they are mixed sufficiently with each other.

The present invention will now be described in detail below.

The liquid epoxy resin composition according to the present invention contains an epoxy resin, an amine latent curing agent and hydrophilic silica and, optionally, a thixotropic agent and/or a filler.

The epoxy resin is suitably a liquid epoxy resin having two or more epoxy groups in its molecule. Examples of suitable epoxy resins include diglycidyl ethers of bisphenol A, bisphenol F, bisphenol AD, brominated bisphenol A, phenol novolak resins, glycerin and polyalkylene oxides; glycidyl esters of carboxylic acids such as dimer acid and isophthalic acid; epoxidized polybutadiene obtained by reaction of polybutadiene with peracetic acid; urethane-modified diglycidyl ethers of bisphenol A, heterocyclic epoxy resins; and mixtures thereof. These epoxy resins may be used singly or as a mixture of two or more. The use of epoxy resins which are liquid at room temperature is preferred. However, it is possible to use crystalline or solid epoxy resins if they are used in conjunction with liquid epoxy resins in which the solid epoxy resins are able to be dissolved.

As the amine curing agent, conventional latent curing agents having two or more primary, secondary or tertiary amine groups, such as dicyandiamide, derivatives of dicyandiamide, imidazole compounds, organic acid hydrazides, amine-adducts and spiroacetal compounds, are suitably used.

Illustrative of suitable imidazole compounds are 2-heptadecylimidazole, 2-phenyl-4,5-dihydroxymethylimidazole, 2-phenyl-4-methyl-5-hydroxymethylimidazole, 2-phenyl-4-benzyl-5-hydroxymethylimidazole, 2,4-diamino-6- 2-methylimidazolyl-(1) - ethyl-5-triazine and an addition product of the triazine with isocyanuric acid. Illustrative of suitable hydrazides are succinohydrazide, adipohydrazide, isophthalohydrazide, o-oxybenzohydrazide and salicylohydrazide. Examples of amine adducts include AMICURE PN-23 (manufactured by Ajinomoto Co., Inc.), AMICURE MY-24 (manufactured by Ajinomoto Co., Inc.) and NOVACURE HX-3721 (manufactured by Asahi Kasei Kogyo K. K.). Examples of spiroacetal compounds include AMICURE GG-215 and AMICURE ATU CARBAMATE (both manufactured by Ajinomoto Co., Inc.). The amine curing agent is generally used in an amount of 3-50 parts by weight, preferably 5-40 parts by weight per 100 parts by weight of the epoxy resin.

Any silica may be used for the purpose of the present invention as long as it is hydrophilic in nature. Non-porous, amorphous silica having silanol groups is a suitable example of the hydrophilic silica. The use of fine amorphous silica powder having a particle size of the primary particles less than 100 nm is particularly preferred. The primary particles may form a secondary structure with a greater particle size. Hydrous silica having an average particle size of 0.01 mm or less may also be suitably used. Illustrative of suitable commercially available hydrophilic silica products are as follows:

Amorphous silica:

AEROSIL #300   with an average particle size of the primary particles of about 7 nm
AEROSIL #200   with an average particle size of the primary particles of about 12 nm
AEROSIL #130   with an average particle size of the primary particles of about 16 nm (manufactured by Japan Aerosil Inc.)

Hydrous silica:

NIPSIL E150    with an average particle size of 4.5 nm
NIPSIL E200A   with an average particle size of 2.0 nm
NIPSIL E220A   with an average particle size of 1.0 nm (manufactured by Japan Silica Kogyo Inc.)

The hydrophilic silica is used for the purpose of imparting shape retentivity at the curing temperature to the composition and of minimizing the change in viscosity and thixotropy of the epoxy resin composition with time. Namely, the hydrophilic silica-containing epoxy resin composition of the present invention is excellent in shape retentivity so that a spot or a pattern of the composition formed by application thereof onto a printed circuit board is not easily spread but retains its shape during curing stage even when the composition used has been stored for a long time.

Thus, the epoxy resin composition obtained by the method of the present invention preferably has a viscosity changing ratio Vc in the range 0.90-1.10, a thixotropy index changing ratio Tc in the range 0.90-1.10 and a coating expansion ratio E in the range 1.00-1.10. These ratios are calculated as hereinbefore described.

As previously mentioned, the epoxy resin composition is prepared according to the invention by mixing the epoxy resin and hydrophilic silica to provide a mixture having a thixotropy index of at least 4, blending the resulting mixture with an amine latent curing agent and then thoroughly mixing the blend at a temperature of 5°-40°C until the thixotropy index thereof is decreased to 2 or less.

It is important that the hydrophilic silica should be used in an amount sufficient to provide a mixture of the silica and epoxy resin having a thixotropy index of at least 4, preferably 4-8 in order to obtain the epoxy resin composition having the desired characteristics. This amount varies with the kind of the epoxy resin and curing agent used but is generally at least 0.05 part by weight, preferably 0.1 to 0.5 part by weight per 1 part by weight of the curing agent. The curing agent may be mixed with the epoxy resin and the hydrophilic silica after the latter two ingredients have been mixed. Alternatively, the three ingredients may be simultaneously mixed with each other to obtain a blend having a thixotropy index of at least 4.

It is also important that the resulting blend should be further thoroughly mixed at a temperature of 5-40°C until a thixotropy index of 2 or less, preferably 1.5 or less is reached. This commingling step may be effected with a planetary mixer, a universal mixer, a roll mixer or the like blending machine, and is performed preferably at room temperature, for a period of time of at least 2 hours, preferably 3-5 hours. The mixing time varies with the kind of the mixer and the kind of the blend to be mixed.

After the formation of the above blend whose thixotropy index has been reduced to 2 or less, a filler and/or a thixotropic agent are incorporated into the composition.

The filler incorporated into the epoxy resin composition to control the viscosity or the like properties of the composition may be organic or inorganic. Illustrative of the inorganic fillers are crystalline silica, fused silica, alumina, titania, calcium carbonate, talc, clay, calcium silicate, mica, glass fibers, glass powder, glass flakes and whiskers of various kinds. The amount of the inorganic filler is 5-50 %, preferably 10-40 % based on the weight of the composition. The inorganic filler preferably has an average particle size of 5-50 μm. Examples of the organic filler include nylon powder and polystyrene powder. The organic filler may be used in an amount of 5-50 % by weight, preferably 10-40 % by weight based on the weight of the composition.

In the present invention a thixotropic agent having an average particle size of 100 nm or less may be used. Examples of such a thixotropic agent include super-fine silica and alumina, aluminum hydroxide, fibrous magnesium oxysulfate, powdery asbesto, fibrous silica, fibrous potassium titanate, scale-like mica, and a montmorillonite-organic salt composite so called bentonite. The super-fine silica may be hydrophilic silica or hydrophobic silica. The thixotropic agent is used in an amount of 0.5-15 parts by weight, preferably 1-10 parts by weight per 100 parts by weight of the epoxy resin.

The liquid epoxy resin composition of the present invention may further contain various conventional additives such as a reactive diluent, a pigment, an antifoaming agent and a leveling agent.

The reactive diluent, which should be mixed with the epoxy resin before the formation of the above blend, is a compound which has at least one epoxy group and which is a low viscosity liquid at room temperature. Examples of suitable reactive diluents include phenyl glycidyl ether, polyethylene glycol diglycidyl ether, polypropylene glycol diglycidyl ether, methyl glycidyl ether, propyl glycidyl ether, pentaerythritol polyglycidyl ether, sorbitan polyglycidyl ether, n-butyl glycol glydidyl ether and 2-ethylhexyl glycidyl ether. The reactive diluent is used for decreasing the viscosity of the composition. Such a viscosity control is advantageous when the composition is applied onto printed wiring boards by screen printing or with a dispenser. However, when the epoxy resin used is low in viscosity, it is not necessary to use a reactive diluent even when the composition is to be applied by screen printing or with a dispenser.

The other additives may be added at any point in time during the course of preparation of the composition.

The liquid epoxy resin composition of the present invention, when used as an adhesive for fixing electric parts on a printed wiring board, may be applied onto a surface of the board by a screen printing method, a pin transfer method, a method using a dispenser or any other known method to obtain a desired coating pattern. The epoxy resin composition may also be used as a coating liquid for the formation of a solder resist on printed wiring boards.

The following examples will further illustrate the present invention, in which "part" is by weight.

Example 1

A blend of the following ingredients was prepared:

| (A) | Epoxy resin Diglycidyl ether of bisphenol A (EPIKOTE 828, manufactured by Yuka-Shell Epoxy Inc.) | 100 parts |
|---|---|---|
| (B) | Amine curing agent Amine adduct (AMICURE PN-23, manufactured by Ajinomoto Co., Inc.) | 25 parts |
| (C) | Hydrophilic silica (AEROSIL #300, manufactured by Japan Aerosil Inc.) | 5 parts |

The above blend was mixed with a planetary mixer at room temperature for 4 hours to give a composition (I) having a thixotropy index of 1.5.

Example 2

To 130 parts of the composition (I) obtained in Example 1 were added 50 parts of talc (inorganic filler) having an average particle size of about 0.0032 mm and the mixture was commingled with a planetary mixer to give a composition (II).

Example 3

To 130 parts of the composition (I) obtained in Example 1 were added 5 parts of hydrophobic, silicone oil-treated silica (thixotropic agent, AEROSIL R202 manufactured by Japan Aerosil Inc.) having an average particle size (primary particle) of 14 nm and the mixture was commingled with a planetary mixer to give a composition (III).

Example 4

To 130 parts of the composition (I) obtained in Example 1 were added 5 parts of hydrophobic, octylsilane-treated silica (thixotropic agent, AEROSIL 805 manufactured by Japan Aerosil Inc.) having an average particle size (primary particle) of 12 nm and the mixture was commingled with a planetary mixer to give a composition (IV).

### Example 5

To 130 parts of the composition (I) obtained in Example 1 were added 50 parts of nylon powder (organic filler, ORGANOL 2001, manufactured by Toray-Lylsan Inc.) having a particle size of 5-40 nm and the mixture was commingled with a planetary mixer to give a composition (V).

### Example 6

To 130 parts of the composition (I) obtained in Example 1 were added 50 parts of calcined clay (inorganic filler, HARGES NO. 30, manufactured by Shiraishi Calcium K. K.) having an average particle size of about 0.0015 mm and the mixture was commingled with a planetary mixer to give a composition (VI).

### Comparative Example 1

The same blend of the raw materials as used in Example 1 was mixed with a planetary mixer at room temperature for 15 minutes to obtain a composition (C-1) having a thixotropy index of 4.5.

### Comparative Example 2

Comparative Example 1 was repeated in the same manner as described except that the amount of the hydrophilic silica was reduced to 1 part, thereby obtaining a composition (C-2) having a thixotropy index of 2.5.

### Comparative Example 3

The composition (C-2) obtained in Comparative Example 2 was further mixed at room temperature for 4 hours with a planetary mixer to obtain a composition (C-3) having a thixotropy indes of 1.1.

### Comparative Example 4

Comparative Example 1 was repeated in the same manner as described except that a hydrophobic silica as used in Example 3 was substituted for the hydrophilic silica to obtain a composition (C-4) with a thixotropy index of 4.5.

### Comparative Example 5

Comparative Example 4 was repeated in the same manner as described except that the mixing was performed for 4 hours to obtain a composition (C-5) with a thixotropy index of 3.0.

Each of the thus obtained compositions (I) to (V) and (C-1) to (C-5) was then measured for the viscosity changing ratio Vc, thixotropy index changing ratio Tc and coating expansion ratio E thereof. The results are shown in Table 1.

The measurement was performed as follows:

Viscosity Changing Ratio Vc:

Sample composition is stored in a closed vessel at 40 °C for 20 days. The viscosity of the sample immediately after the preparation thereof and after the storage is measured at 25 °C using rotating viscometer (EHD Viscometer manufactured by Tokyo Keiki Inc.) operated at 0.5 rpm (revolution per minute) using a cone of 3° x 28 mm. The value after 5 minutes from the start of the measurement is scored. The viscosity changing ratio Vc is calculated by the equation:

$$Vc = V_1/V_0$$

wherein $V_0$ is the viscosity of the sample immediately after the preparation thereof and $V_1$ is the viscosity after the storage. The ratio thus obtained is evaluated on the basis of the following rating:

C+ :   poor (Vc > 1.3)
B+ :   no good (1.3 $\geqq$ Vc >1.1)
A :    good (1.1 $\geqq$ Vc $\geqq$ 0.9)
B- :   no good (0.9 > Vc $\geqq$ 0.7)

C- :     poor (0.7 > Vc)

Thixotropy Index Changing Ratio Tc:

In addition to the above viscosity measurement at 0.5 rpm revolution condition, viscosity is also measured at 5 rpm revolution condition. From these results, the thixotropy index of the sample is calculated by the equation:

$$\text{Thixotropy Index} = v_{0.5}/v_5$$

where $v_{0.5}$ is the viscosity measured at 25 °C and 0.5 rpm and $v_{5.0}$ is the viscosity measured at 25 °C and 5.0 rpm. The thixotropy index changing ratio Tc is calculated as follows:

$$Tc = T_1/T_0$$

wherein $T_0$ is the thixotropy index of the sample immediately after the preparation thereof and $T_1$ is the thixotropy index after the storage at 40 °C for 20 days. The ratio thus obtained is evaluated on the basis of the following rating:

C+ :     poor (Tc > 1.3)
B+ :     no good (1 .3 $\geq$ Tc >1.1)
A :       good (1.1 $\geq$ Tc $\geq$ 0.9)
B- :     no good (0.9 > Tc $\geq$ 0.7)
C- :     poor (0.7 > Tc)

Coating Expansion Ratio E:

A glass epoxy board with a thickness of 1.6 mm is coated with a solder resist (UVR-150G manufactured by Taiyo Ink K. K.) and then with a preflux (C-131R manufactured by Tamura Seisakusho Inc.). Sample composition is applied onto the coated board to form a round coating with a diameter of about 1.0 mm. The coating is then cured at 150 °C for 1 minute in a furnace (TFM-101 manufactured by Saiyo Denki K. K.). After cooling to room temperature, the diameter of the cured coating is measured. The coating expansion ratio E is calculated as follows:

$$E = D_0/D_1$$

wherein $D_0$ is the diameter of the uncured coating and $D_1$ is the diameter of the cured coating. The measured ratio is evaluated according to the following rating:

C :     poor (E > 1.2)
B :     no good (1.2 $\geq$ E >1.1)
A :     good (1.1 $\geq$ E $\geq$ 1.1)

Table 1

| Example No. | 1 | 2 | 3 | 4 | 5 | 6 | | | | | |
|---|---|---|---|---|---|---|---|---|---|---|---|
| Comparative Example No. | | | | | | | 1 | 2 | 3 | 4 | 5 |
| Viscosity changing ratio Vc | A | A | A | A | A | A | C- | C- | A | C- | B- |
| Thixotropy index changing ratio Tc | A | A | A | A | A | A | C- | C- | A | C- | B- |
| Coating expansion ratio E | A | A | A | A | A | A | B | C | C | B | B |

**Claims**

1.  A method of preparing a liquid epoxy resin composition, comprising the steps of:

(a) providing a mixture comprising an epoxy resin and hydrophilic silica and having a thixotropy index of at least 4;

(b) blending said mixture with an amine latent curing agent to obtain a blend;

(c) then thoroughly mixing said blend at a temperature of 5-40°C until the thixotropy index thereof is decreased to 2 or less;

(d) then mixing a filler and/or a thixotropic agent with the thoroughly mixed product obtained in step (c); and

wherein the thixotropy index is defined as:

$$v_{0.5}/v_5$$

where $v_{0.5}$ is the viscosity of the composition measured at 25°C with a rotating viscometer operated at a rotational speed of 0.5 revolution per minute and $v_5$ is the viscosity of said composition measured at 25°C with the same viscometer operated at a rotational speed of 5.0 revolutions per minute.

2. A method as claimed in Claim 1, wherein step (a) is simultaneous with step (b).

3. A method as claimed in Claim 1, wherein step (b) is preceded by step (a).

4. A liquid epoxy resin composition prepared by a method as claimed in any preceding claim.

5. A liquid epoxy resin composition as claimed in Claim 4 and having a viscosity changing ratio Vc in the range 0.90 to 1.10, a thixotropy index changing ratio Tc in the range of 0.90 to 1.10 and a coating expansion ratio E in the range of 1.00 to 1.10, said viscosity changing ratio, thixotropy index changing ratio and coating expansion ratio are calculated as follows:

$$Vc = V_1/V_0$$

wherein $V_0$ is the viscosity of said composition at a given point in time and measured at 25°C with a rotating viscometer with a rotation speed of 0.5 r.p.m. and $V_1$ is the viscosity of said composition after being maintained at 40°C for 20 days from said given point in time and measured in the same conditions as above,

$$Tc = T_1/T_0$$

wherein $T_0$ is the thixotropy index of said composition at said given point in time and $T_1$ is the thixotropy index of said composition after being maintained at 40°C for 20 days from said given point in time, where the thixotropy index is calculated as follows:

$$\text{Thixotropy Index} = v_{0.5}/v_5$$

where $v_{0.5}$ and $v_5$ are as defined in Claim 1, and

$$E = D_1/D_0$$

wherein $D_0$ is the diameter of an uncured coating on a substrate and $D_1$ is the diameter of the coating after curing at 150°C for 1 minute.

**Patentansprüche**

1. Verfahren zur Herstellung einer flüssigen Epoxidharzzusammensetzung, das die folgenden Schritte umfaßt:

(a) Bereitstellen einer Mischung, die ein Epoxidharz und hydrophiles Siliciumdioxid enthält und einen Thixotropie-Index von mindestens 4 aufweist;

(b) Mischen der Mischung mit einem aminlatenten Härtungsmittel zwecks Erhalt eines Gemischs;

(c) anschließendes gründliches Mischen des Gemischs bei einer Temperatur von 5 bis 40 °C, bis deren Thixotropie-Index auf 2 oder darunter gesunken ist;

(d) anschließendes Mischen eines Füllstoffs und/oder eines thixotropischen Mittels mit dem in Schritt (c) gewonnenen und gründlich gemischten Produkt;

wobei der Thixotropie-Index wie folgt definiert ist:

$$v_{0,5}/v_5$$

worin $v_{0,5}$ die bei 25 °C mit einem Rotationsviskosimeter bei einer Drehzahl von 0,5 U/min gemessene Viskosität der Zusammensetzung und $v_5$ die bei 25 °C mit dem gleichen Viskosimeter bei einer Drehzahl von 5,0 U/min gemessene Viskosität der Zusammensetzung sind.

2. Verfahren nach Anspruch 1, bei dem Schritt (a) simultan mit dem Schritt (b) erfolgt.

3. Verfahren nach Anspruch 1, bei dem vor Schritt (b) der Schritt (a) durchgeführt wird.

4. Flüssige Epoxidharzzusammensetzung, die nach einem in einem der vorstehenden Ansprüche beschriebenen Verfahren hergestellt wird.

5. Flüssige Epoxidharzzusammensetzung nach Anspruch 4 und mit einem Viskositätsänderungsverhältnis Vc im Bereich von 0,90 auf 1,10, einem Thixotropie-Index-Änderungsverhältnis Tc im Bereich von 0,90 bis 1,10 und einem Beschichtungsausdehnungsverhältnis E im Bereich von 1,00 bis 1,10, wobei das Viskositätsänderungsverhältnis, das Thixotropie-Index-Änderungsverhältnis und das Beschichtungsausdehnungsverhältnis wie folgt berechnet werden:

$$Vc = V_1/V_0$$

worin $V_0$ die Viskosität der Zusammensetzung, zu einem bestimmten Zeitpunkt und bei 25 °C mit einem Rotationsviskosimeter mit einer Drehzahl von 0,5 U/min gemessen, und $V_1$ die Viskosität der Zusammensetzung nach dem Halten für 20 Tage bei 40 °C, von dem bestimmten Zeitpunkt an gerechnet und unter den gleichen Bedingungen wie oben gemessen, sind,

$$Tc = T_1/T_0$$

worin $T_0$ der Thixotropie-Index der Zusammensetzung zu dem bestimmten Zeitpunkt und $T_1$ der Thixotropie-Index der Zusammensetzung nach dem Halten für 20 Tage bei 40 °C, von dem bestimmten Zeitpunkt an sind, wobei der Thixotropie-Index wie folgt berechnet wird:

$$\text{Thixotropie-Index} = v_{0,5}/v_5$$

worin $v_{0,5}$ und $v_5$ definiert sind wie in Anspruch 1, und

$$E = D_1/D_0$$

worin $D_0$ die Dicke einer ungehärteten Beschichtung auf einem Substrat und $D_1$ die Dicke der Beschichtung nach dem Aushärten für 1 min bei 150 °C sind.

## Revendications

1. Méthode de préparation d'une composition de résine époxyde liquide, comprenant les étapes de :

    (a) mise en oeuvre d'un mélange comprenant une résine époxyde et une silice hydrophile et ayant un indice de thixotropie d'au moins 4;

    (b) combinaison dudit mélange avec un agent réactif latent aminé pour obtenir un mélange;

    (c) puis le mélange intime dudit mélange à une température de 5-40°C jusqu'à ce que son indice de thixotropie ait diminué jusqu'à 2 ou moins;

    (d) puis le mélange d'une charge et/ou d'un agent thixotropique avec le produit intimement mélangé obtenu dans l'étape (c) ; et

    où l'indice de thixotropie est défini comme :

$$v_{0,5}/v_5$$

    où $v_{0,5}$ est la viscosité de la composition mesurée à 25°C avec un viscosimètre rotatif fonctionnant à une vitesse de rotation de 0,5 tour par minute et $v_5$ est la viscosité de ladite composition mesurée à 25°C avec le même viscosimètre fonctionnant à une vitesse de rotation de 5,0 tours par minute.

2. Méthode selon la Revendication 1, dans laquelle l'étape (a) est simultanée à l'étape (b).

3. Méthode selon la Revendication 1, dans laquelle l'étape (b) est précédée de l'étape (a).

4. Composition de résine époxyde liquide préparée par une méthode selon l'une quelconque des revendications précédentes.

5. Composition de résine époxyde liquide selon la Revendication 4 et ayant un taux de changement de viscosité Vc compris dans la gamme de 0,90 à 1,10, un taux de changement d'indice de thixotropie Tc dans la gamme de 0,90 à 1,10 et un taux de dilatation du revêtement E dans la gamme de 1,00 à 1,10, lesdits taux de changement de viscosité, taux de changement d'indice de thixotropie et taux de dilatation du revêtement étant calculés comme suit:

$$Vc = V_1/V_0$$

où $V_0$ est la viscosité de ladite composition à un point donné dans le temps et mesurée à 25°C avec un viscosimètre rotatif ayant une vitesse de rotation de 0,5 tr/min et $V_1$ est la viscosité de ladite composition après qu'elle a été maintenue à 40°C pendant 20 jours à partir dudit point donné dans le temps et mesurée dans les mêmes conditions que ci-dessus,

$$Tc = T_1/T_0$$

où $T_0$ est l'indice de thixotropie de ladite composition audit point donné dans le temps et $T_1$ est l'indice de thixotropie de ladite composition après qu'elle a été maintenue à 40°C pendant 20 jours à partir dudit point donné dans le temps, où l'indice de thixotropie est calculé comme suit :

$$\text{Indice de thixotropie} = v_{0,5}/v_5$$

où $v_{0,5}$ et $v_5$ sont les valeurs définies dans la Revendication 1, et

$$E = D_1/D_0$$

où $D_0$ est le diamètre d'un revêtement non durci sur un substrat et $D_1$ est le diamètre du revêtement après durcissement à 150°C pendant 1 minute.